# EUROPEAN PATENT APPLICATION

(11) **EP 4 836 647 A1**
(43) Date of publication of application: **04.11.2026**
(21) Application number: 24911408.3
(22) Date of filing: 27.12.2024
(51) Int. Cl.: H10H 29/855, G09F 9/33, H01L 25/075

(54) **ANTI-CROSSTALK MICRO-DISPLAY LIGHT-EMITTING PIXEL AND MANUFACTURING METHOD THEREFOR**

(30) Priority: 29.12.2023 CN 202311840767; 01.11.2024 CN 202411551521; 01.11.2024 CN 202422668577 U; 01.11.2024 CN 202422668030 U; 01.11.2024 CN 202422668572 U
(71) Applicant: Innovision Technology (Suzhou) Co., Ltd, Suzhou, Jiangsu 215000 (CN)
(72) Inventor: ZHU, Youliang, Suzhou, Jiangsu 215000 (CN); LIN, Xiao, Suzhou, Jiangsu 215000 (CN); PAN, Anlian, Suzhou, Jiangsu 215000 (CN); WANG, Yazhou, Suzhou, Jiangsu 215000 (CN)
(74) Representative: Winter, Brandl - Partnerschaft mbB
(86) International application number: PCT/CN2024/142995
(87) International publication number: WO 2025/140487

(57) **Abstract**

The present invention discloses an anti-crosstalk microdisplay light-emitting pixel and a fabricating method thereof, and relates to the field of semiconductor technologies. The microdisplay light-emitting pixel includes: a driving backplane; and a display module, the display module being disposed on the driving backplane, the display module including a light-emitting unit and a trench structure, the light-emitting unit being in conduction with an anode contact in the driving backplane, the trench structure surrounding the light-emitting unit and penetrating through a vertical area in which the display module is located, the trench structure being filled with a metal material, and the light-emitting unit being an inorganic compound semiconductor. Based on the technical solutions provided in this application, light-emitting constraint is performed by using a through-type trench structure, to achieve better optical crosstalk isolation.

## Description

This application claims priority to the following Patent Applications: Chinese Patent Application No. 202311840767.0, filed on December 29, 2023, and entitled "ANTI-CROSSTALK MICRODISPLAY LIGHT-EMITTING PIXEL AND FABRICATING METHOD THEREOF, AND MICRODISPLAY"; Chinese Patent Application No. 2024115515216, filed on November 1, 2024, and entitled "ANTI-CROSSTALK MICRODISPLAY LIGHT-EMITTING PIXEL AND FABRICATING METHOD THEREOF"; Chinese Patent Application No. 2024226685771, filed on November 1, 2024, and entitled "ANTI-CROSSTALK MICRODISPLAY LIGHT-EMITTING PIXEL"; Chinese Patent Application No. 2024226680301, filed on November 1, 2024, and entitled "ANTI-CROSSTALK MICRODISPLAY LIGHT-EMITTING PIXEL"; and Chinese Patent Application No. 2024226685729, filed on November 1, 2024 and entitled "ANTI-CROSSTALK MICRODISPLAY LIGHT-EMITTING PIXEL", which are incorporated herein by reference in their entirety.

### TECHNICAL FIELD

The present invention relates to the field of semiconductor technologies, and in particular, to an anti-crosstalk microdisplay light-emitting pixel and a fabricating method thereof.

### BACKGROUND

In the field of semiconductor technologies, crosstalk and light-emitting distribution between microdisplay light-emitting pixels have significant impacts on display quality and efficiency of coupling into an optical waveguide. For example, an emission angle of a light emitting diode (Light Emitting Diode, LED) chip with a normal vertical structure is approximately ±55°.

In the related technology, technical solutions such as black matrix (Black Matrix, BM) between pixels or fabrication of micro lens (Micro Lens) are often used to realize constraint of crosstalk and light-emitting distribution between microdisplay light-emitting pixels. In the solution of black matrix, the black matrix is an organic material system, has insufficient temperature resistance and mechanical strength, and has defects in reliability. In addition, the black matrix has light absorption, causing a loss of overall brightness. In the solution of micro lens, a prepared micro lens belongs to an organic material system, has insufficient temperature resistance and mechanical strength, and has defects in reliability. In addition, complete optical isolation cannot be implemented between pixels. When a pixel size continues to shrink, the emission angle of +55° may cause the problem of crosstalk between adjacent pixels before entering the micro lens.

Therefore, it is urgently needed to provide a new preparation scheme for a microdisplay light-emitting pixel that can avoid the foregoing defects.

### SUMMARY

An objective of the present invention is to provide an anti-crosstalk microdisplay light-emitting pixel and a fabricating method thereof. Light-emitting constraint is performed by using a through-type trench structure, to achieve better optical crosstalk isolation.

In order to achieve the above invention objective, the present invention proposes the following technical solutions.

According to one aspect, an anti-crosstalk microdisplay light-emitting pixel is provided, a size of the microdisplay light-emitting pixel is in an interval of 0.5 um to 50 um, and the microdisplay light-emitting pixel includes:
a driving backplane; and
a display module, the display module being disposed on the driving backplane, the display module including a light-emitting unit and a trench structure, the light-emitting unit being in conduction with an anode contact in the driving backplane, the trench structure surrounding the light-emitting unit and penetrating through a vertical area in which the display module is located, the trench structure being filled with a metal material, and the light-emitting unit being an inorganic compound semiconductor.

In an optional implementation, the display module includes at least a first display device layer; and the first display device layer includes:
a first light-emitting unit, a first P-type ohmic contact layer in the first light-emitting unit being connected to a via, and the first light-emitting unit being in conduction with the anode contact in the driving backplane through the via filled with a metal material;
a first insulation layer, the first insulation layer being filled and formed outside the first light-emitting unit; and
a first trench structure, the first trench structure penetrating through the first insulation layer, one end of the first trench structure being connected to a first N-type ohmic contact layer in the first light-emitting unit, and the other end being connected to an upper surface of the driving backplane.

In a possible implementation, a surface size of the via is less than a surface size of the first P-type ohmic contact layer.

In a possible implementation, the surface size of the via is greater than a surface size of the anode contact in the driving backplane.

In an optional implementation, the display module further includes a second display device layer disposed above the first display device layer; and the second display device layer includes:
a second insulation layer, the second insulation layer being filled and formed on a side of the first display device layer that is away from the driving backplane; and
a second trench structure, the second trench structure penetrating through the second insulation layer and the first N-type ohmic contact layer, and one end of the second trench structure being connected to the first trench structure.

In an optional implementation, a width of the second trench structure is less than a width of the first trench structure.

In an optional implementation, the first N-type ohmic contact layer includes a first part and a second part that are stacked in a direction away from the driving backplane, a surface size of the second part is greater than a surface size of the first part, and one end of the first trench structure is connected to the second part.

In an optional implementation, a second trench structure is connected above the first trench structure, and a bottom of the second trench structure penetrates through the second part, so that the second trench structure is connected to the first trench structure.

In an optional implementation, the display module includes at least a third display device layer; and the third display device layer includes:
a second light-emitting unit, a bonding layer being provided between a second P-type ohmic contact layer in the second light-emitting unit and the driving backplane, the second light-emitting unit being in conduction with the anode contact in the driving backplane through the bonding layer, and a surface of the second N-type ohmic contact layer in the second light-emitting unit being covered with a part of cathode layer;
a third insulation layer, the third insulation layer being filled and formed outside the second light-emitting unit; and
a third trench structure, the third trench structure penetrating through the third insulation layer, and one end of the third trench structure being connected to the cathode layer.

In an optional implementation, the cathode layer includes a central cathode layer and side cathode layers on two sides, and the central cathode layer covers the surface of the second N-type ohmic contact layer; and
a side wall of the second light-emitting unit and a surface of the driving backplane are covered with a passivation layer, and the side cathode layers cover a surface of the passivation layer;
   or
the side cathode layers cover a surface of a side of the third insulation layer that is away from the driving backplane.

In an optional implementation, when the side cathode layer covers the surface of the side of the third insulation layer that is away from the driving backplane, the side wall of the second light-emitting unit and the surface of the driving backplane are further covered with a passivation layer.

In an optional implementation, the trench structure is located inside the display module;
or
the trench structure is located at an outer periphery of the display module.

In an optional implementation, a trench pattern of the trench structure in a top view includes:
one of a circle, a rectangle, a hexagon, and an octagon.

In an optional implementation, the display module further includes a micro lens; and
the micro lens is disposed on the light-emitting unit and the trench structure.

In an optional implementation, the metal material filled in the trench structure includes:
aluminum, nickel vanadium, and copper deposited vertically in sequence; or
deposited aluminum; or
deposited tungsten.

In a possible implementation, an overall depth of the trench structure is not less than an overall depth of the light-emitting unit.

In a possible implementation, a width of the trench structure is in an interval of 90 nm to 5 um.

In a possible implementation, a depth of the trench structure is in an interval of 0.4 um to 5 um.

In a possible implementation, an angle of the trench structure gradually increases along a direction away from the driving backplane.

According to another aspect, a method for preparing a microdisplay light-emitting pixel is provided, where the method is used for preparing the microdisplay light-emitting pixel according to the foregoing aspect, and the method includes:
preparing a driving backplane; and
preparing a display module combined on the driving backplane, the display module including a light-emitting unit and a trench structure, the light-emitting unit being in conduction with an anode contact in the driving backplane, the trench structure surrounding the light-emitting unit and penetrating through a vertical area in which the display module is located, the trench structure being filled with a metal material, and the light-emitting unit being an inorganic compound semiconductor.

In an optional implementation, the preparing a display module combined on the driving backplane includes:
performing step etching on the inorganic compound semiconductor to prepare a first light-emitting unit;
performing step filling on the first light-emitting unit by using an insulating material, to form a first insulation layer;
etching the first insulation layer to form a via connected to a first P-type ohmic contact layer in the first light-emitting unit and a first trench structure surrounding the first light-emitting unit;
filling the via and the first trench structure with a metal material, and the first light-emitting unit, the first insulation layer, and the first trench structure being combined to form a first display device layer; and
combining the first display device layer with the driving backplane through a hybrid bonding process, and during combining, the first light-emitting unit being in conduction with the anode contact in the driving backplane through the via filled with a metal material.

In an optional implementation, after the combining the first display device layer with the driving backplane, the method further includes:
removing a compound substrate in a first light-emitting unit; and
performing surface coarsening on the first light-emitting unit after the substrate is removed.

In an optional implementation, after forming the first display device layer, the method further includes:
filling the first display device layer with an insulating material to form a second insulation layer;
etching the second insulation layer to form a second trench structure with one end connected to the first trench structure; and
filling the second trench structure with a metal material, and the second insulation layer and the second trench structure being combined to form a second display device layer.

In an optional implementation, the preparing a display module combined on the driving backplane includes:
combining the inorganic compound semiconductor prepared with a bonding layer and the driving backplane prepared with a bonding layer through a hybrid bonding process, and during combining, the inorganic compound semiconductor being in conduction with the anode contact in the driving backplane through the bonding layer;
performing step etching on the inorganic compound semiconductor and the bonding layer to prepare a second light-emitting unit;
performing step filling on the second light-emitting unit by using an insulating material, to form a third insulation layer; etching the third insulation layer to form a third trench structure surrounding the second light-emitting unit; and filling the third trench structure with a metal material; removing a part of the third insulation layer on a top surface of the second light-emitting unit through a patterning process, to expose a second N-type ohmic contact layer in the second light-emitting unit; and covering a surface of the second N-type ohmic contact layer and a surface of a side of the third insulation layer that is away from the driving backplane with a cathode layer;
   or
covering a surface of the second light-emitting unit and a surface of the driving backplane with a passivation layer; removing a part of the passivation layer on a top surface of the second light-emitting unit through a patterning process, to expose a second N-type ohmic contact layer in the second light-emitting unit; covering a surface of the second N-type ohmic contact layer and a surface of the passivation layer with a cathode layer; performing step filling on the second light-emitting unit by using an insulating material, to form a third insulation layer; etching the third insulation layer to form a third trench structure surrounding the second light-emitting unit; and filling the third trench structure with a metal material.

In an optional implementation, in the method of covering a surface of the second N-type ohmic contact layer and a surface of a side of the third insulation layer that is away from the driving backplane with a cathode layer, before the performing step filling on the second light-emitting unit by using an insulating material, to form a third insulation layer, the method further includes:
covering the surface of the second light-emitting unit and the surface of the driving backplane with a passivation layer.

In an optional implementation, after the preparing a display module combined on the driving backplane, the method further includes:
preparing a micro lens on the light-emitting unit and the trench structure.

Compared with the prior art, the present invention has the following beneficial effects.

The trench structure is etched in the display module of the microdisplay light-emitting pixel, and the metal material is filled in the trench structure. Through the through-type trench structure, better optical crosstalk isolation is implemented, and a depth of the trench structure can be customized to constrain the emission angle. In addition, the design process of the trench structure is relatively mature, with guaranteed mass production and yield.

Further, the light-emitting unit and the trench structure in the display module belong to an inorganic material system, which has good temperature resistance and mechanical strength, and its reliability is guaranteed.

Further, design concepts of a front trench structure, a back trench structure, and a combination of the front trench structure and the back trench structure are provided, and different schemes can be freely selected as needed.

### BRIEF DESCRIPTION OF THE DRAWINGS

FIG. 1 is a schematic diagram of an optical crosstalk phenomenon corresponding to a related technology;
FIG. 2 is a schematic structural diagram of a microdisplay light-emitting pixel according to an embodiment of this application;
FIG. 3 is a circuit schematic diagram of a driving circuit according to an embodiment of this application;
FIG. 4 is a schematic diagram of an optical crosstalk phenomenon according to an embodiment of this application;
FIG. 5 is a schematic structural diagram of a microdisplay light-emitting pixel according to an embodiment of this application;
FIG. 6 is a schematic diagram of a trench pattern according to an embodiment of this application;
FIG. 7 is a schematic structural diagram of a microdisplay light-emitting pixel in a design concept of a front trench structure according to an embodiment of this application;
FIG. 8 is a schematic structural diagram of a microdisplay light-emitting pixel with a micro lens according to an embodiment of this application;
FIG. 9 is a schematic structural diagram of a microdisplay light-emitting pixel with a micro lens according to an embodiment of this application;
FIG. 10 is a schematic structural diagram of a microdisplay light-emitting pixel in a design concept of a back trench structure according to an embodiment of this application;
FIG. 11 is a schematic structural diagram of a microdisplay light-emitting pixel in a design concept of a back trench structure according to an embodiment of this application;
FIG. 12 is a schematic structural diagram of a microdisplay light-emitting pixel in a design concept of a back trench structure according to an embodiment of this application;
FIG. 13 is a schematic structural diagram of a microdisplay light-emitting pixel in a design concept of a back trench structure according to an embodiment of this application;
FIG. 14 is a schematic diagram of light-emitting constraint according to an embodiment of this application;
FIG. 15 is a schematic diagram of light-emitting constraint according to an embodiment of this application;
FIG. 16 is a schematic structural diagram of a microdisplay light-emitting pixel with a micro lens according to an embodiment of this application;
FIG. 17 is a schematic structural diagram of a microdisplay light-emitting pixel with a micro lens according to an embodiment of this application;
FIG. 18 is a schematic structural diagram of a microdisplay light-emitting pixel in a design concept of a combination of a front trench structure and a back trench structure according to an embodiment of this application;
FIG. 19 is a schematic structural diagram of a microdisplay light-emitting pixel with a micro lens according to an embodiment of this application;
FIG. 20 is a method flowchart of a method for preparing a microdisplay light-emitting pixel according to an embodiment of this application;
FIG. 21 is a schematic structural diagram of a driving backplane according to an embodiment of this application;
FIG. 22 is a schematic structural diagram of an inorganic compound semiconductor according to an embodiment of this application;
FIG. 23 is a schematic structural diagram of an inorganic compound semiconductor on which step etching is performed according to an embodiment of this application;
FIG. 24 is a schematic structural diagram of an inorganic compound semiconductor for which a trench structure is prepared according to an embodiment of this application;
FIG. 25 is a schematic structural diagram of a metal-filled inorganic compound semiconductor according to an embodiment of this application;
FIG. 26 is a schematic structural diagram of a combination of an inorganic compound semiconductor and a driving backplane according to an embodiment of this application;
FIG. 27 is a schematic structural diagram of a microdisplay light-emitting pixel with a roughened surface according to an embodiment of this application;
FIG. 28 is a schematic structural diagram of an inorganic compound semiconductor on which step etching is performed according to an embodiment of this application;
FIG. 29 is a schematic structural diagram of an inorganic compound semiconductor prepared with a bonding layer according to an embodiment of this application;
FIG. 30 is a schematic structural diagram of a driving backplane prepared with a bonding layer according to an embodiment of this application;
FIG. 31 is a schematic structural diagram of a combination of an inorganic compound semiconductor and a driving backplane according to an embodiment of this application;
FIG. 32 is a schematic structural diagram of a bonding structure on which step etching is performed according to an embodiment of this application;
FIG. 33 is a schematic structural diagram of covering a second light-emitting unit with a passivation layer and a cathode layer according to an embodiment of this application;
FIG. 34 is a schematic structural diagram of a bonding structure on which step filling is performed according to an embodiment of this application;
FIG. 35 is a schematic structural diagram of a bonding structure for which a trench structure is prepared according to an embodiment of this application;
FIG. 36 is a schematic structural diagram of a bonding structure on which step filling is performed according to an embodiment of this application; and
FIG. 37 is a schematic structural diagram of a bonding structure for which a trench structure is prepared according to an embodiment of this application.

Reference numerals:
10-driving backplane, 11-anode contact, 20-display module, 21-first display device layer, 22-second display device layer, 23-third display device layer, 30-light-emitting unit, 31-first light-emitting unit, 311-first P-type ohmic contact layer, 312-via, 313-first N-type ohmic contact layer, 316-first substrate, 317-first active quantum well layer, 32-second light-emitting unit, 321-second P-type ohmic contact layer, 322-bonding layer, 323-second N-type ohmic contact layer, 324-second substrate, 325-second active quantum well layer, 40-trench structure, 41-first trench structure, 42-second trench structure, 43-third trench structure, 50-micro lens, 61-first insulation layer, 62-second insulation layer, 63-third insulation layer, 70-cathode layer, 71-central cathode layer, 72-side cathode layer, and 80-passivation layer.

### DETAILED DESCRIPTION

In order to make objectives, technical solutions, and advantages of the present invention clearer, the technical solutions in the embodiments of the present invention are to be clearly and completely described below with reference to the accompanying drawings in the embodiments of the present invention. Apparently, the embodiments to be described are a part rather than all of the embodiments of the present invention. All other embodiments obtained by a person of ordinary skill in the art on the basis of the embodiments of the present invention without creative efforts shall fall within the protection scope of the present invention.

In the description of the present invention, it should be understood that the orientations or positional relationships indicated by terms such as "perpendicular", "upper", "lower", "top", "side", "inner", and "outer" are based on the orientations or positional relationships shown in the accompanying drawings. These terms are merely for ease and brevity of description of the present invention rather than indicating or implying that the apparatuses or elements mentioned need to have specific orientations or need to be constructed or manipulated according to specific orientations, and therefore shall not be construed as a limitation to the present invention. In addition, terms "first" and "second" are used only for the purpose of description, and shall not be construed as indicating or implying relative importance or implying a quantity of indicated technical features. Therefore, features defining "first" and "second" may explicitly or implicitly include one or more of the features. In the description of the present invention, unless otherwise specified, "a plurality of" means two or more.

In the descriptions of the present invention, it should be noted that, unless otherwise explicitly specified or defined, terms "mount", "connect", and "connection" are to be understood in a broad sense. For example, the connection may be a fixed connection, a detachable connection, or an integral connection; the connection may be a mechanical connection or an electrical connection; or the connection may be a direct connection, an indirect connection through an intermediary, or internal communication between two elements. The specific meanings of the above terms in the present invention may be understood according to specific circumstances for a person of ordinary skill in the art.

A conventional anti-crosstalk design scheme of microdisplay light-emitting pixel has defects in many aspects, such as the following examples.

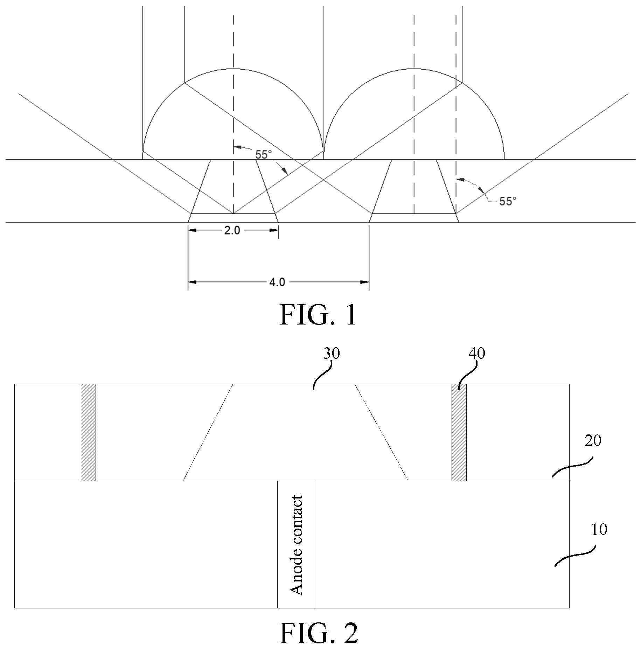

For an anti-crosstalk design scheme of preparation of a micro lens, a micro lens prepared in the scheme belongs to an organic material system, has insufficient temperature resistance and mechanical strength, and has defects in reliability. In addition, complete optical isolation cannot be implemented between pixels. When a pixel size continues to shrink, and when an emission angle is ±55°, the problem of crosstalk between adjacent pixels may occur before entering the micro lens. FIG. 1 is used as an example for description. A device of a GaN Micro LED vertical structure with a pixel size of 4 um and a light-emitting unit of 2 um is used as an example. The vertical structure of the device has a smallest emission angle of ±55° of a conventional LED device, which is smaller than an emission angle of ±60° to ±70° of an LED device with a horizontal structure and an inverted structure. When the emission angle is ±55°, optical crosstalk between adjacent pixels cannot be completely isolated because light emitted from an active light-emitting area may pass through the entire light-emitting unit and becomes multi-surface emission. An actual light angle is more complex than that shown in FIG. 1. Because the light is refracted and reflected in the light-emitting unit for a plurality of times, the caused optical crosstalk between pixels is worse.

For an anti-crosstalk design scheme of using the black matrix, the black matrix blocks light through light absorption characteristics of black matrix materials, to realize optical crosstalk isolation between pixels. The black matrix is an organic material system, has insufficient temperature resistance and mechanical strength, and has defects in reliability. In addition, the black matrix has light absorption, causing a loss of overall brightness. In some solutions, a trapezoidal structure similar to the black matrix is formed through metal patterning deposition and lift-off for isolation, to avoid the reliability problem. However, both the black matrix and the metal patterning lift-off solutions cannot adapt to a particularly small pixel size. For example, when the pixel size is less than 5 um, a resolution of the black matrix and an issue of photoresist mask lifting off during metal patterning lift-off both pose challenges to yield and mass production viability.

To avoid the foregoing problem, in an embodiment of this application, a technical solution is proposed to achieve better optical crosstalk isolation by performing light-emitting constraint by using a through-type trench structure.

It may be understood that the trench structure in this embodiment of this application is a technology applied to the field of microdisplay (Micro-LED). The trench structure is prepared by using a metal material, has features of optical crosstalk optimization, emission angle convergence, enhancement of an electrical transmission function, and resistance to severe environments such as high temperature, and is greatly different from a similar structure in conventional large-scale panel display.

On the one hand, the similar structure in the conventional large-scale panel display cannot be directly applied to the field of microdisplay. For the conventional large-scale panel display, such as CN110969952A, which is a typical conventional large-scale panel display structure, an LED is used as a backlight light source. However, because a large space between lamp balls of each LED causes strong graininess of image display and extremely uneven luminance distribution, which makes an audience feel dazzled, a hollow grid structure additionally prepared in manners such as compressing, printing, and spraying is generally used. The hollow grid structure is placed around the LED to constrain a light-emitting range, and after light is irradiated to a diffusion film, light is averaged by using the diffusion film, to achieve a relatively uniform display effect. A function of the hollow grid structure in this solution may be used as a common pixel crosstalk isolating means. However, after entering the field of microdisplay, preparation of the hollow grid and alignment precision of placement of the LED light source cannot be implemented. Therefore, other solutions are needed to implement similar functions in the field of microdisplay.

On the other hand, for the typical conventional large-scale panel display structure shown in CN110969952A, although a light shielding frame can also play a role of optical crosstalk optimization, compared with the trench structure in this patent application, differences are mainly as follows.
(1) A pixel pitch and a pixel size in CN110969952A are generally large, and are basically on the order of several hundred micrometers or even a few millimeters, and have a low requirement on a line width of a light shielding frame for blocking between pixels. The light shielding frame is mostly an organic material such as a black adhesive, and temperature resistance is generally around or below 200 °C. The trench structure in this application is applied to the field of microdisplay, a pixel pitch and a pixel size are generally on the order of micrometers to tens of micrometers, and the trench structure is a metal material, which has very high temperature resistance.
(2) Due to a difference of implementation materials, the light shielding frame in CN110969952A has only an optical function, while the trench structure in this application further has a function of enhancing an electrical transmission function, to spread current distribution better. The trench structure and a cathode or a cathode-related connection of the light-emitting unit need to form a good contact and evenly distribute the current.

A specific structure of the microdisplay light-emitting pixel provided in this application is described below.

An embodiment of this application provides an anti-crosstalk microdisplay light-emitting pixel (referred to as a microdisplay light-emitting pixel for short below). A size of the microdisplay light-emitting pixel is in an interval of 0.5 um to 50 um. As shown in FIG. 2, the microdisplay light-emitting pixel includes:
a driving backplane 10; and a display module 20, the display module 20 being disposed on the driving backplane 10, the display module 20 including a light-emitting unit 30 and a trench structure 40, the light-emitting unit 30 being in conduction with an anode contact in the driving backplane 10, the trench structure 40 surrounding the light-emitting unit 30 and penetrating through a vertical area in which the display module 20 is located, the trench structure 40 being filled with a metal material, and the light-emitting unit 30 being an inorganic compound semiconductor.

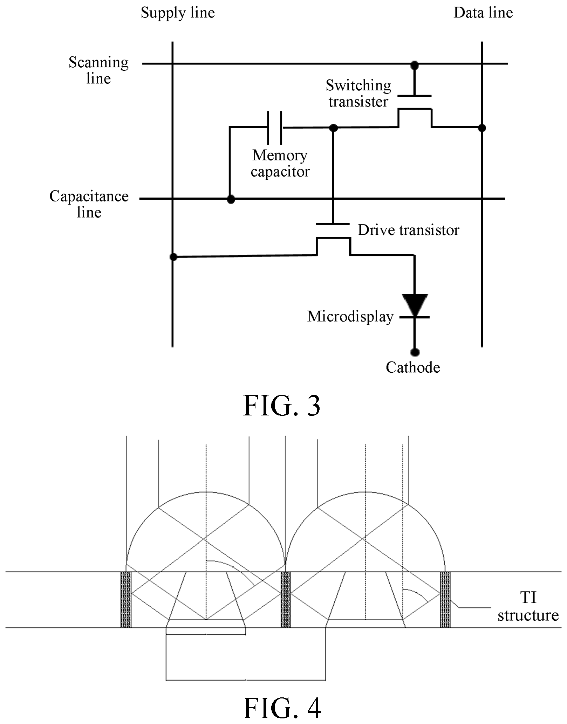

The driving backplane 10 is an active driving backplane combining one or more of a thin film transistor (TFT), a low-temperature polycrystalline silicon (LTPS), a CMOS integrated circuit, and a high electron mobility transistor (HEMT). Specifically, the driving backplane 10 is provided with a driving circuit, and the driving circuit is provided with at least one anode contact 11. For example, a circuit structure of the driving circuit is shown in FIG. 3. It should be noted that, the driving circuit in this embodiment is active driving, and the circuit diagram shown in this embodiment is merely a simple schematic diagram. The driving circuit may include an active, passive, or semi-passive control circuit. All anodes included in the driving circuit may be arranged linearly or arranged in an array, and any anode contact 11 is located in the middle or at the edge of the driving backplane 10. This is not limited in this embodiment.

The display module 20 is designed with a through-type trench structure 40. The trench structure 40 surrounds a light-emitting unit 30 in the display module 20 and is filled with a metal material. In addition, the light-emitting unit 30 is an inorganic compound semiconductor. The entire display module 20 is of pure inorganic structure and has high reliability. For example, as shown in FIG. 4, the design of the trench structure 40 (that is, a TI structure in the figure) may perform light-emitting constraint on the emission angle, thereby preventing optical crosstalk between adjacent microdisplay light-emitting pixels.

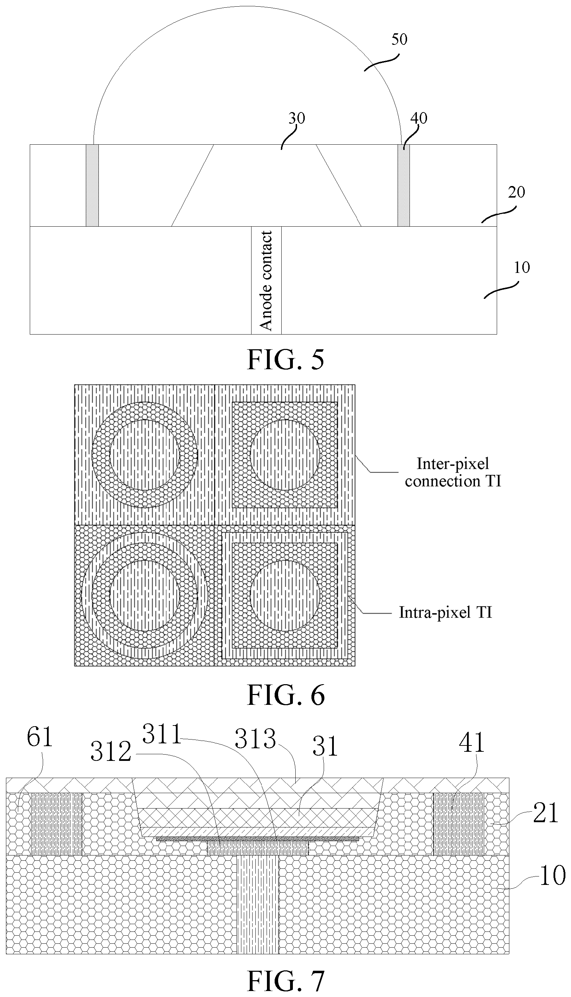

Further, as shown in FIG. 5, the display module 20 further includes a micro lens 50; and the micro lens 50 is disposed on the light-emitting unit 30 and the trench structure 40. The micro lens 50 may be disposed at the top of the display module 20. First, basic light-emitting constraint is performed through the trench structure 40, and then the micro lens 50 is used to further perform optical crosstalk isolation on light emitted from the light-emitting unit 30. A material of the micro lens 50 may be a compound semiconductor, or may be a subsequently-disposed dielectric material such as silicon oxide or silicon nitride.

Further, the light-emitting unit 30 in the display module 20 is an inorganic compound semiconductor, and is usually a wafer or an appropriately sized area cut from a wafer. The wafer is used as an example, and the wafer refers to a compound formed by two or more elements in a determined atomic ratio, and has semiconductor properties such as a determined forbidden band width and an energy band structure. The wafer may be specifically a crystalline inorganic compound (for example, a III-V group or a II-VI group compound semiconductor), then prepares a layer forming an electrical contact on a surface of the compound, and may be flexibly combined during subsequent compound stacking In this embodiment, the light-emitting unit 30 involves ultraviolet light, green light, blue light AlGaN, an InGaN ternary material system whose substrate material may be GaN, Si, SiC, Sapphire, or the like, and long waves such as red light and infrared. The red light may be an InGaN ternary material system or quaternary AlGaInP red light compound LED epitaxy of GaAs substrate, and the infrared mainly includes compound epitaxy of InP, GaAs, AlGaAs, and other material systems. In addition, a shape corresponding to a top view of the light-emitting unit 30 is not limited in this embodiment, and may be a circle or another polygon such as a rectangle, a hexagon, or an octagon. In addition, an etching depth corresponding to the light-emitting unit 30 may be in an interval of 0.3 um to 3 um.

In an embodiment, when the light-emitting unit 30 includes red light compound epitaxy, the red light compound epitaxy may be a quaternary AlGaInP material or a ternary InGaN material, and may be based on a substrate such as GaAs, Si, Sapphire, or Ga2O3. Table 1 below is an example of a brief structure, where P-GaAs may be replaced with P-GaP and P-AlGaAs.

**Table 1**

| Layer names | Materials | Layer names | Materials |
|---|---|---|---|
| P-type ohmic contact layer | P-GaAs | P-type ohmic contact layer | P-GaN |
| Active quantum well layer | AIGaInP | Active quantum well layer | InGaN&GaN |
| N-type ohmic contact layer | N-GaAs | N-type ohmic contact layer | N-GaN |
| Etch stop layer | N-AIGaInP | Etch stop layer | AIN&GaN |
| Substrate | N-GaAs | Substrate | Si |

In an embodiment, when the light-emitting unit 30 includes a blue light or green light compound semiconductor, the blue light or green light compound semiconductor is an InGaN ternary compound, and may be based on a substrate such as Si, Sapphire, or Ga2O3. An example of a structure thereof is shown in Table 2 below.

**Table 2**

| Layer names | Materials | Layer names | Materials |
|---|---|---|---|
| P-type ohmic contact layer | P-GaN | P-type ohmic contact layer | P-GaN |
| Active quantum well layer | InGaN&GaN | Active quantum well layer | InGaN&GaN |
| N-type ohmic contact layer | N-GaN | N-type ohmic contact layer | N-GaN |
| Etch stop layer | InGaN | Etch stop layer | AIN&GaN |
| Substrate | GaN | Substrate | Si |

In an embodiment, when the light-emitting unit 30 includes an ultraviolet compound semiconductor, the ultraviolet compound semiconductor is an AlGaN ternary compound and may be based on a substrate such as Si, Sapphire, or SiC. An example of a structure thereof is shown in Table 3 below.

**Table 3**

| Layer names | Materials | Layer names | Materials |
|---|---|---|---|
| P-type ohmic contact layer | P-GaN | P-type ohmic contact layer | P-GaN |
| Active quantum well layer | AIGaN&InGaN | Active quantum well layer | AIGaN&InGaN |
| N-type ohmic contact layer | N-GaN | N-type ohmic contact layer | N-GaN |
| Buffer layer | AIN&AIGaN | Buffer layer | AIN&GaN |
| Substrate | Si | Substrate | Sapphire |

In an embodiment, when the light-emitting unit 30 includes an infrared compound semiconductor, the infrared compound semiconductor is an AlGaAs ternary compound, and may be based on a substrate such as GaAs or InP. An example of a structure thereof is shown in Table 4 below.

**Table 4**

| Layer names | Materials | Layer names | Materials |
|---|---|---|---|
| P-type ohmic contact layer | P-GaAs | P-type ohmic contact layer | P-AIGaAs |
| Active quantum well layer | AIGaAs&GaAs | Active quantum well layer | AIGaAs&GaAs |
| N-type ohmic contact layer | N-GaAs | N-type ohmic contact layer | N-AIGaAs |
| Etch stop layer | AIGaInP | Etch stop layer | AIGaInP |
| Substrate | GaAs | Substrate | GaAs |

As shown in the foregoing Table 1 to Table 4, different compound materials are selected to prepare devices, so that light-emitting components of different wavelengths can be obtained. Different materials are selected as materials of the P-type and N-type ohmic contact layers based on characteristics of different compounds. For example, the P-type ohmic contact layer uses an ITO transparent conductive film, and the N-type ohmic contact layer uses a metal In+ITO transparent conductive film, which may be used as a common-type ohmic contact material. Specially, a P-type ohmic contact layer of GaN may be a single layer or a composite layer of a metal such as Ni, Au, Ag, or Al, an N-type ohmic contact layer of GaN may be a single layer or a composite layer of a metal such as Ti, Cr, Ni, or Al, a P-type ohmic contact layer of GaAs may be a single layer, an alloy, or a composite layer of a metal such as Au, Be, or Zn, and an N-type ohmic contact layer of GaAs may be a single layer, an alloy, or a composite layer of a metal such as Au, Ge, Ni, Pt, or In.

Further, the metal material filled in the trench structure 40 includes: aluminum (Al), nickel vanadium (NiV), and copper (Cu) deposited vertically in sequence; or deposited aluminum; or deposited tungsten (W). In the trench structure 40, the filled metal material may be formed by first depositing a seed layer of Al and NiV using plasma vapor deposition, followed by electroplating of Cu. Al may serve as a reflective metal to improve brightness, and Al may also serve as an N-type ohmic contact metal for step etching down to the N-type ohmic contact layer, realizing an N-connection. NiV acts as an adhesion layer and a barrier layer, used for adhering Al and Cu and for preventing migration of Al. Cu is used for electroplating. Further, NiV may be replaced with any one of Ni, Ti, and TiN; and the metal material may also be directly deposited by plasma vapor deposition at room temperature or by thermal deposition of metals, such as metal Al or metal W. Further, before depositing Al or W, TiN metal deposition may be performed. It may be understood that in addition to the foregoing types of metal materials, the seed layer in the trench structure 40 may further be a single layer or a plurality of layers of metals such as Ti, Ni, Cr, Au, Ge, Al, Pt, Ta, W, or their nitrides. This is not specifically limited in this application. Further, a trench pattern of the trench structure 40 in a top view includes: one of a circle, a rectangle, a hexagon, and an octagon. In a top view of the microdisplay light-emitting pixel, the trench pattern around the light-emitting unit may be a circle, a rectangle, a hexagon, an octagon, or the like, and this is not limited in this embodiment.

Further, trench structures 40 corresponding to adjacent light-emitting units are connected to each other; or trench structures 40 corresponding to adjacent light-emitting units are isolated from each other by using an insulating medium. The trench structure 40 may implement an inter-pixel connection pattern shown in FIG. 6, or may implement an intra-pixel pattern shown in FIG. 6. FIG. 6 merely uses circular and rectangular trench patterns as examples for description.

Further, an overall depth of the trench structure 40 is not less than an overall depth of the light-emitting unit 30. When the trench structure is etched, an etching depth corresponding to the trench structure 40 is greater than or equal to an etching depth corresponding to the light-emitting unit 30, so that the trench structure 40 may constrain an emission angle of the light-emitting unit 30 through a sufficient depth. In addition, the depth of the trench structure is in an interval of 0.4 um to 5 um.

Further, a width of the trench structure 40 is in an interval of 90 nm to 5 um. By designing the width of the trench structure 40 within a particular range, not only the trench structure 40 is prevented from occupying a horizontal space of a pixel too much, but also it can be ensured that the trench structure 40 has a sufficient thickness for anti-crosstalk.

Further, an angle of the trench structure 40 gradually increases along a direction away from the driving backplane 10. The formed trench structure 40 may be implemented from the bottom to the top through a plurality of angles, such as a plurality of angles gradually increasing along the direction away from the driving backplane 10, thereby strictly constraining the emission angle from the bottom first, and then uniformly emitting light through the top. In addition, the trench structure 40 may also be implemented from the bottom to the top through one angle. In addition, the angle may be in an interval of 90°±30°, and is optimal at 90°±10°. In this application, based on a difference between sequences of trench preparing processes, three different specific structure design concepts of microdisplay light-emitting pixels are provided.
(1) A design concept in which the microdisplay light-emitting pixel adopts a front trench structure. In a preparing process corresponding to this structure design, the trench structure 40 is first prepared in the display module 20, and then the display module 20 is combined with the driving backplane 10.

Specifically, as shown in FIG. 7, the display module 20 includes at least a first display device layer 21, where the first display device layer 21 includes a first light-emitting unit 31, a first P-type ohmic contact layer 311 in the first light-emitting unit 31 is connected to a via 312, and the first light-emitting unit 31 is in conduction with the anode contact in the driving backplane 10 through the via 312 filled with a metal material; a first insulation layer 61, the first insulation layer 61 being filled and formed outside the first light-emitting unit 31; and a first trench structure 41, the first trench structure 41 penetrating through the first insulation layer 61, one end of the first trench structure 41 being connected to a first N-type ohmic contact layer 313 in the first light-emitting unit 31, and the other end being connected to an upper surface of the driving backplane 10, extending from a plane to a periphery of a display area and connected to a common cathode at the periphery of the driving backplane 10. The metal material filled in the via 312 may be the same as or different from the metal material filled in the first trench structure 41, for example, using the same deposited Al, NiV, or Cu. The first insulation layer 61 may be a single layer or a composite layer of a medium layer such as silicon oxide, silicon nitride, SIC, SICN, Ti3O5, or Ni2O5. A thickness of the first insulation layer 61 and a depth of the first trench structure 41 are generally substantially equal to a thickness of the first light-emitting unit 31, and the depth of the first trench structure 41 is limited by the thickness of the first light-emitting unit 31.

Further, a surface size of the via 312 is less than a surface size of the first P-type ohmic contact layer 311. Further, the surface size of the via 312 is greater than a surface size of the anode contact in the driving backplane 10. Because the via 312 in the display device layer needs to be aligned with the anode contact in the driving backplane 10 for bonding, in the foregoing size design, difficulty during bonding may be reduced, and process preparation may be facilitated.

Further, as shown in FIG. 7, the first N-type ohmic contact layer 313 includes a first part and a second part that are stacked in a direction away from the driving backplane 10, a surface size of the second part is greater than a surface size of the first part, and one end of the first trench structure 41 is connected to the second part. An electrical structure of a cathode is prepared by using a thinned second part.

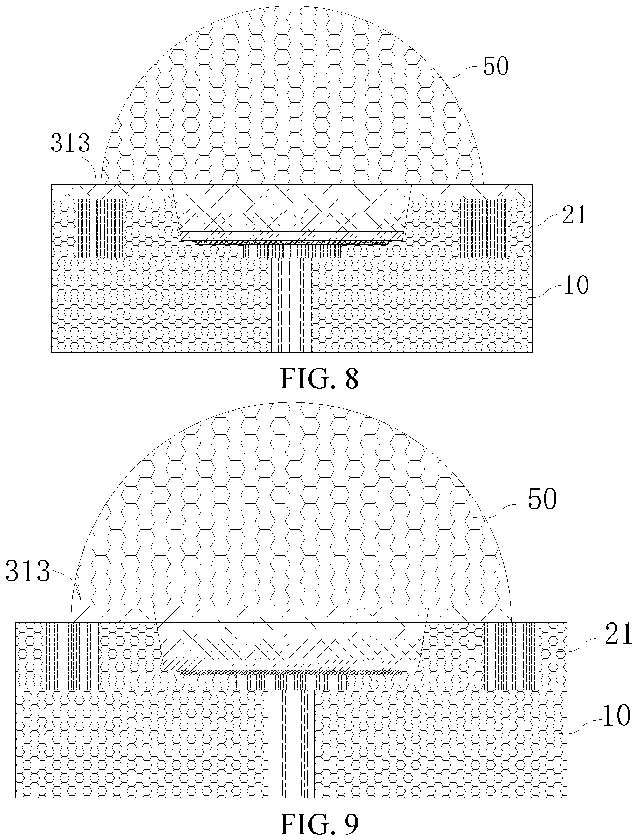

Further, as shown in FIG. 8 and FIG. 9, a micro lens 50 may be disposed on the first display device layer 21. For the design concept of the front trench structure, in an embodiment, as shown in FIG. 8, the first N-type ohmic contact layer 313 is not clipped during etching of the micro lens 50. In another embodiment, as shown in FIG. 9, the first N-type ohmic contact layer 313 is partially clipped during etching of the micro lens 50, achieving N-type contact conduction of the cathode in some areas and enabling complete isolation between microdisplay light-emitting pixels.

(2) A design concept in which the microdisplay light-emitting pixel adopts a back trench structure. In a preparing process corresponding to this structure design, the display module 20 is first combined with the driving backplane 10, and then the trench structure 40 is prepared in the display module 20.

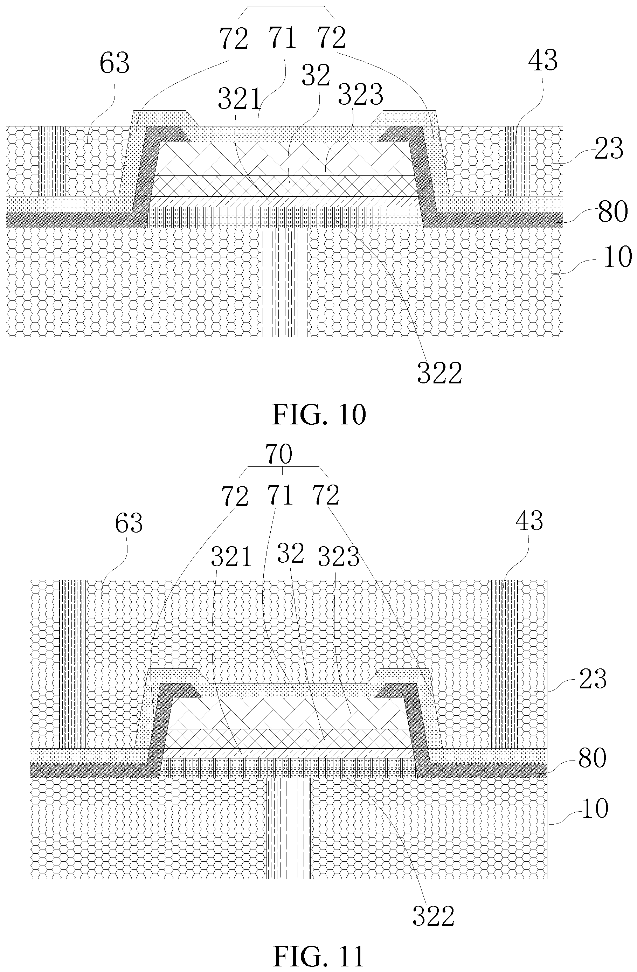

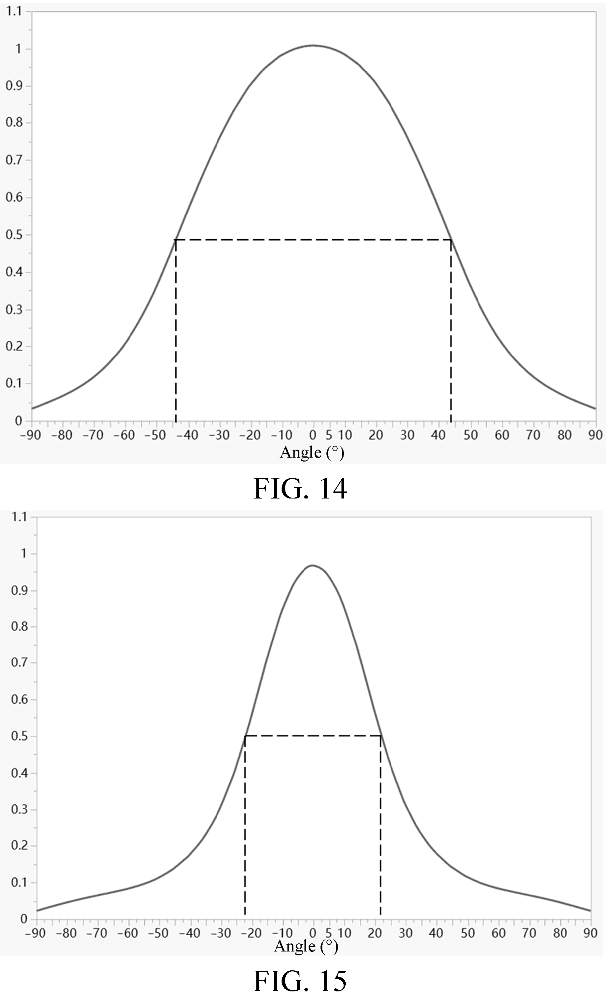

Specifically, as shown in FIG. 10 to FIG. 13, the display module 20 includes at least a third display device layer 23, where the third display device layer 23 includes a second light-emitting unit 32, a bonding layer 322 is provided between a second P-type ohmic contact layer 321 in the second light-emitting unit 32 and the driving backplane 10, the second light-emitting unit 32 is in conduction with the anode contact in the driving backplane 10 through the bonding layer 322, and a surface of the second N-type ohmic contact layer 323 in the second light-emitting unit 32 is covered with a part of cathode layer 70; a third insulation layer 63, the third insulation layer 63 being filled and formed outside the second light-emitting unit 32; and a third trench structure 43, the third trench structure 43 penetrating through the third insulation layer 63, and one end of the third trench structure 43 being connected to the cathode layer 70. The bonding layer 322 may be a non-transparent metal material, for example, a single layer or a plurality of layers of a metal such as Au, Sn, Al, Cu, or W. Alternatively, the bonding layer 322 may be a transparent metal oxide material, for example, a transparent conductive film such as ITO or ZnO. The third insulation layer 63 may be a single layer or a composite layer of a medium layer such as silicon oxide, silicon nitride, SIC, SICN, Ti3O5, or Ni2O5. A thickness of the third insulation layer 63 and a depth of the third trench structure 43 are greater than or equal to a thickness of the second light-emitting unit 32, and the depth of the third trench structure 43 may be set to be any value greater than or equal to the thickness of the second light-emitting unit 32. For example, based on the structure shown in FIG. 10, when the depth of the third trench structure 43 is the same as the thickness of the second light-emitting unit 32, as shown in FIG. 14, the emission angle decreases from initial ±55° to ±45°; and based on the structure shown in FIG. 11, when the depth of the third trench structure 43 is greater than twice the thickness of the second light-emitting unit 32, as shown in FIG. 15, the emission angle decreases from initial ±55° to ±17°.

Further, the cathode layer 70 includes a central cathode layer 71 and side cathode layers 72 on two sides, and the central cathode layer 71 covers the surface of the second N-type ohmic contact layer 323.

In a possible design, as shown in FIG. 10 and FIG. 11, a side wall of the second light-emitting unit 32 and a surface of the driving backplane 10 are covered with a passivation layer 80, and the side cathode layers 72 cover a surface of the passivation layer 80. The passivation layer 80 may be a single layer or a composite layer of a medium layer such as Al2O3, SiO2, or Si3N4. Insulation protection is provided for the second light-emitting unit 32 and the driving backplane 10 through the passivation layer 80, and a common cathode connection is realized by using the side cathode layer 72 covered on the surface of the passivation layer 80 and the central cathode layer 71 covered on the surface of the second N-type ohmic contact layer 323.

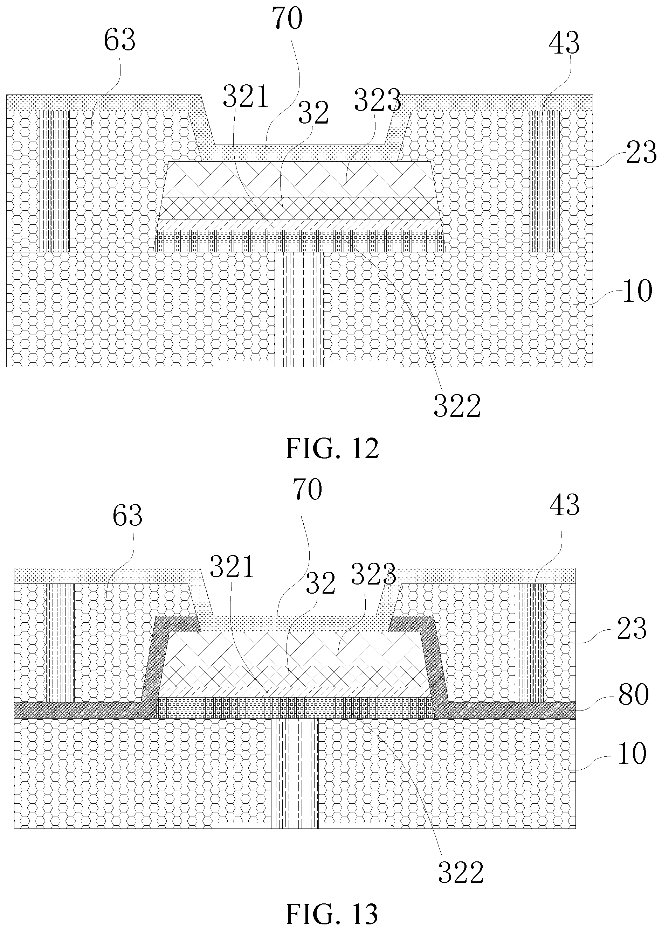

In another possible design, as shown in FIG. 12, the side cathode layer 72 covers a surface of a side of the third insulation layer 63 that is away from the driving backplane 10. The common cathode connection is realized by using the side cathode layer 72 covered on the surface of the third insulation layer 63 and the central cathode layer 71 covered on the surface of the second N-type ohmic contact layer 323.

Further, as shown in FIG. 13, when the side cathode layer 72 covers the surface of the side of the third insulation layer 63 that is away from the driving backplane 10, the side wall of the second light-emitting unit 32 and the surface of the driving backplane 10 are further covered with a passivation layer 80. The passivation layer 80 may be a single layer or a composite layer of a medium layer such as Al2O3, SiO2, or Si3N4. That is, the third insulation layer 63 may be directly connected to the surface of the driving backplane 10 as shown in FIG. 12, the passivation layer 80 is not disposed between the third insulation layer 63 and the driving backplane 10, and the medium layer on the driving backplane 10 is used to withstand over-etching. Alternatively, as shown in FIG. 13, the passivation layer 80 is disposed between the third insulation layer 63 and the driving backplane 10. The passivation layer 80 is used as an etch stop layer, and insulation protection is provided for the second light-emitting unit 32 and the driving backplane 10 through the passivation layer 80.

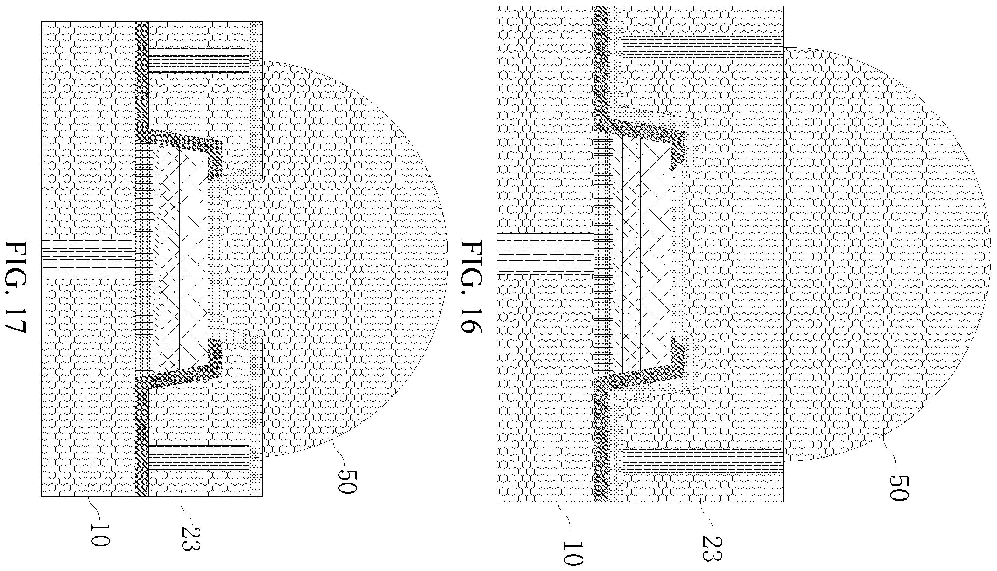

Further, a micro lens 50 may be disposed on the third display device layer 23. For example, a structure shown in FIG. 16 corresponds to adding the micro lens 50 to the structure corresponding to FIG. 11, and a structure shown in FIG. 17 corresponds to adding the micro lens 50 to the structure corresponding to FIG. 13.

(3) A design concept in which the microdisplay light-emitting pixel adopts a combination of a front trench structure and a back trench structure. In a preparing process corresponding to this structure design, the design concept of the front trench structure is first adopted to prepare a group of trench structures 40 in a display device layer of the display module 20, and then the display module 20 is combined with the driving backplane 10. Subsequently, the design concept of the back trench structure is further adopted. For the combined devices, another display device layer is added to the display module 20 to prepare another group of trench structures 40.

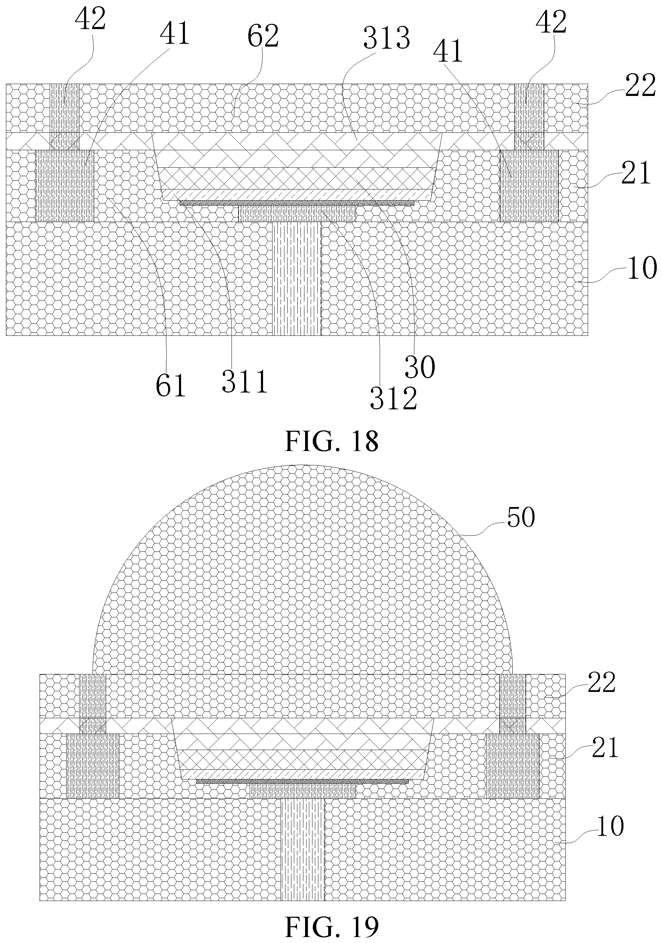

Specifically, as shown in FIG. 18, based on the first display device layer 21, the display module 20 further includes a second display device layer 22 disposed above the first display device layer 21, where the second display device layer 22 includes a second insulation layer 62, and the second insulation layer 62 is filled and formed on a side of the first display device layer 21 that is away from the driving backplane 10; and a second trench structure 42, the second trench structure 42 penetrating through the second insulation layer 62 and the first N-type ohmic contact layer 313, and one end of the second trench structure 42 being connected to the first trench structure 41. The second insulation layer 62 may be a single layer or a composite layer of a medium layer such as silicon oxide, silicon nitride, SIC, SICN, Ti3O5, or Ni2O5. A thickness of the second insulation layer 62 and a depth of the second trench structure 42 are not related to a thickness of the first light-emitting unit 31, and the depth of the second trench structure 42 may be set freely.

Further, a width of the second trench structure 42 is smaller than a width of the first trench structure 41. On the one hand, a photographing alignment deviation can be reserved, thereby reducing a process difficulty. On the other hand, it can be ensured that the first trench structure 41 is connected to the first N-type ohmic contact layer 313, to implement cathode communication. Typically, the second trench structure 42 on the back surface has 50% of the size of the first trench structure 41 on the front surface.

Further, as shown in FIG. 18, the first N-type ohmic contact layer 313 includes a first part and a second part that are stacked in a direction away from the driving backplane 10, a surface size of the second part is greater than a surface size of the first part, and one end of the first trench structure 41 is connected to the second part. An electrical structure of a cathode is prepared by using a thinned second part.

Further, a second trench structure 42 is connected above the first trench structure 41, and a bottom of the second trench structure 42 penetrates through the second part, so that the second trench structure 42 is connected to the first trench structure 41.

Further, as shown in FIG. 19, a micro lens 50 may be disposed on the second display device layer 22.

In conclusion, according to the microdisplay light-emitting pixel provided in this embodiment of this application, the trench structure is etched in the display module of the microdisplay light-emitting pixel, and the metal material is filled in the trench structure. Through the through-type trench structure, better optical crosstalk isolation is implemented, and a depth of the trench structure can be customized to constrain the emission angle. In addition, the design process of the trench structure is relatively mature, with guaranteed mass production and yield.

Further, the light-emitting unit and the trench structure in the display module belong to an inorganic material system, which has good temperature resistance and mechanical strength, and its reliability is guaranteed.

Further, design concepts of a front trench structure, a back trench structure, and a combination of the front trench structure and the back trench structure are provided, and different schemes can be freely selected as needed.

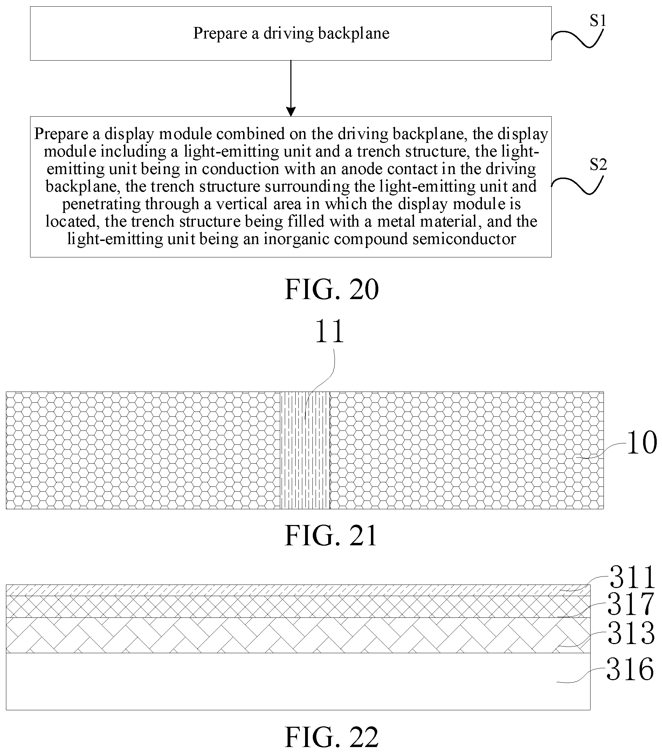

The following describes the method for preparing a microdisplay light-emitting pixel in the foregoing embodiment. The method is used for preparing the microdisplay light-emitting pixel in the foregoing embodiment. As shown in FIG. 20, the method may include the following steps.

S1: Prepare a driving backplane.

For example, a cross-sectional structure of a single pixel of the driving backplane is shown in FIG. 21. The driving backplane 10 includes a through anode contact 11, and an insulating medium is disposed around the anode contact 11.

S2: Prepare a display module combined on the driving backplane, the display module including a light-emitting unit and a trench structure, the light-emitting unit being in conduction with an anode contact in the driving backplane, the trench structure surrounding the light-emitting unit and penetrating through a vertical area in which the display module is located, the trench structure being filled with a metal material, and the light-emitting unit being an inorganic compound semiconductor.

For example, a cross-sectional structure of the inorganic compound semiconductor is shown in FIG. 22. The inorganic compound semiconductor includes at least the following layers sequentially stacked from bottom to top: a first substrate 316, a first N-type ohmic contact layer 313, a first active quantum well layer 317, and a first P-type ohmic contact layer 311.

In a possible implementation, after S2, the method further includes the following step: preparing a micro lens on the light-emitting unit and the trench structure. The micro lens may be prepared and formed through etching, and a material of the micro lens may be a compound semiconductor, or may be a subsequently-disposed dielectric material such as silicon oxide or silicon nitride.

For the design concept of the front trench structure in the foregoing embodiment, S2 may specifically include the following steps.

S211: Perform step etching on the inorganic compound semiconductor to prepare a first light-emitting unit.

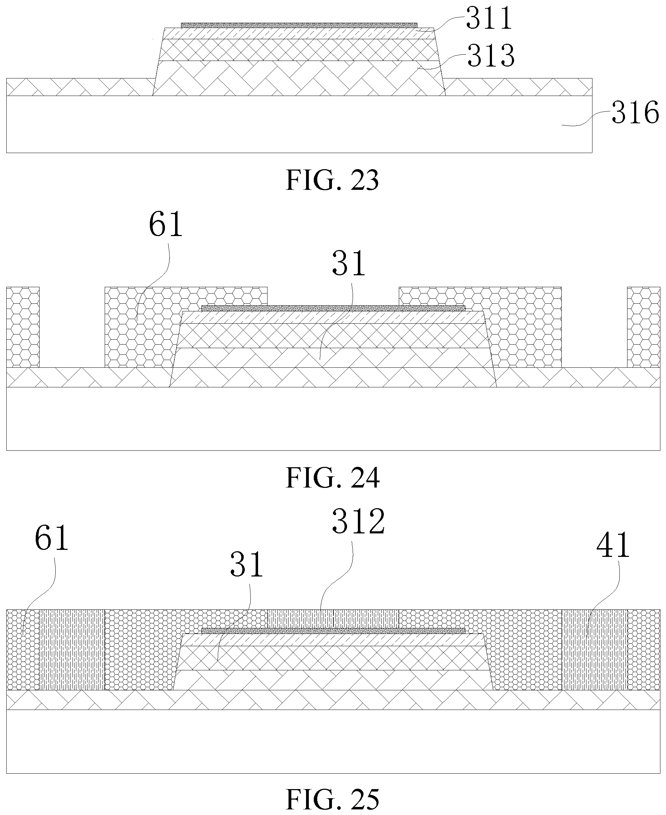

Specifically, as shown in FIG. 23, step etching is performed on the inorganic compound semiconductor to the first N-type ohmic contact layer 313 by using a patterning etching solution such as plasma dry etching, to prepare the first light-emitting unit 31, and an etching depth is in a range of 0.3 um to 3 um.

S212: Perform step filling on the first light-emitting unit by using an insulating material, to form a first insulation layer.

Specifically, step filling is performed on the first light-emitting unit by using a single layer or a composite layer of a medium layer such as silicon oxide, silicon nitride, SIC, SICN, Ti3O5, or Ni2O5, to form the first insulation layer.

S213: Etch the first insulation layer to form a via connected to a first P-type ohmic contact layer in the first light-emitting unit and a first trench structure surrounding the first light-emitting unit.

Specifically, as shown in FIG. 24, the first insulation layer 61 is etched by using a patterning etching solution such as plasma dry etching, to implement the via of the first P-type ohmic contact layer 311, and trench isolation around the first light-emitting unit 31. A thickness of the first insulation layer 61 and a depth of the first trench structure 41 are greater than or equal to a depth of pixel etching, and generally range from 0.4 um to 5 um. A width of the first trench structure 41 ranges from 90 nm to 5 um. An angle of the first trench structure 41 is 90°±30°, and is optimal at 90°+10°.

S214: Fill the via and the first trench structure with a metal material, and the first light-emitting unit, the first insulation layer, and the first trench structure are combined to form a first display device layer.

Specifically, as shown in FIG. 25, the via 312 and the first trench structure 41 are filled with a metal material through a metal backfill process. For example, metals Al, NiV, and Cu are sequentially disposed in the via 312 and the first trench structure 41; or metal Al is disposed in the via 312 and the first trench structure 41; or metal W is disposed in the via 312 and the first trench structure 41. In this structure, both optical pixel string isolation and electrical connection of the cathode may be completed. A seed layer corresponding to the filled metal material may further be a single layer or a plurality of layers of metals such as Ti, Ni, Cr, Au, Ge, Al, Pt, Ta, W, or their nitrides. Further, after the filling is completed, chemical mechanical planarization (Chemical Mechanical Planarization, CMP) may be adopted to remove excess metal on the surface and planarize the surface of the filled metal material.

S215: Combine the first display device layer with the driving backplane through a hybrid bonding process, and during combining, the first light-emitting unit is in conduction with the anode contact in the driving backplane through the via filled with a metal material.

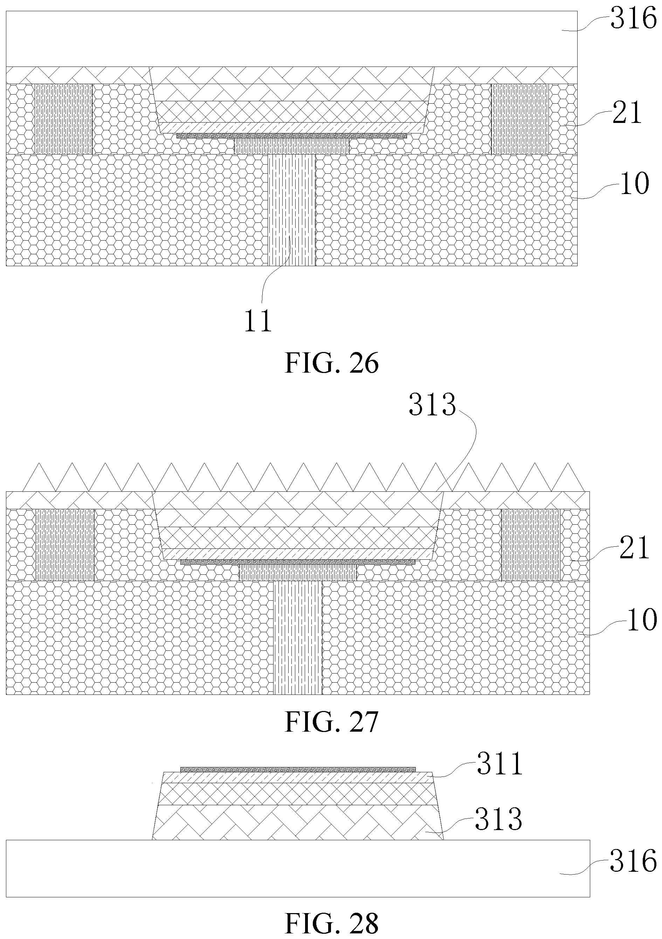

As shown in FIG. 26, during combining, a metal via area in the first display device layer 21 is connected to the anode contact 11 of the driving backplane, and the cathode of the first display device layer 21 is connected to a peripheral common cathode of the driving backplane 10 through the first trench structure 41.

In a possible implementation, after S215, the method further includes the following step: removing a compound substrate in the first light-emitting unit; and performing surface coarsening on the first light-emitting unit after the substrate is removed. The compound substrate of the combined first light-emitting unit 31 is removed. By removing the substrate and thinning the compound, N contact is turned on and the cathode is thinned, thereby reducing optical crosstalk between pixels, to obtain a structure shown in FIG. 7. Further, as shown in FIG. 27, surface coarsening is performed on the first light-emitting unit 31 after the substrate is removed, to enhance light extraction efficiency.

It may be understood that, if the design concept of the front trench structure is adopted, an advantage is that an N-type ohmic contact can be directly formed to the first light-emitting unit; and a disadvantage lies in that a pattern has been defined for the first light-emitting unit during bonding, which needs to be combined with the driving backplane with particular precision, and is limited by the thickness of the first light-emitting unit in the first display device layer, so that the thickness of the first trench structure cannot be customized very flexibly.

It may be understood that in the steps S211 to S215, subsequent preparation is based on step etching to the first N-type ohmic contact layer. In another design, the step etching may completely penetrate the inorganic compound semiconductor other than the first substrate 316 as shown in FIG. 28. Correspondingly, a process step of extending the first N-type ohmic contact layer 311 to connect to the first trench structure 41 is added to connect the cathode of the first display device layer 21 to the peripheral common cathode of the driving backplane 10 through the first trench structure 41.

For the design concept of the combination of a front trench structure and a back trench structure in the foregoing embodiment, after S215, the method may further include the following steps.

S216: Fill the first display device layer with an insulating material to form a second insulation layer.

Specifically, filling is performed on the first display device layer by using a single layer or a composite layer of a medium layer such as silicon oxide, silicon nitride, SIC, SICN, Ti3O5, or Ni2O5, to form a second insulation layer.

S217: Etch the second insulation layer to form a second trench structure with one end connected to the first trench structure.

Specifically, the second insulation layer is etched by using a patterning etching solution such as plasma dry etching, to implement trench isolation around the first light-emitting unit in the second insulation layer. The trench isolation is the second trench structure. A width of the second trench structure ranges from 90 nm to 5 um, and an angle of the second trench structure is 90°±30°, and is optimal at 90°±10°.

S218: Fill the second trench structure with a metal material, and the second insulation layer and the second trench structure are combined to form a second display device layer.

Specifically, the second trench structure is filled with a metal material through a metal backfill process. For example, metals Al, NiV, and Cu are sequentially disposed in the second trench structure; or metal Al is disposed in the second trench structure; or metal W is disposed in the second trench structure. In this structure, both optical pixel string isolation and electrical connection of the cathode may be completed. A seed layer corresponding to the filled metal material may further be a single layer or a plurality of layers of metals such as Ti, Ni, Cr, Au, Ge, Al, Pt, Ta, W, or their nitrides. Further, after the filling is completed, CMP may be adopted to remove excess metal on the surface and planarize the surface of the filled metal material.

It may be understood that, if the design concept of the combination of the front trench structure and the back trench structure is adopted, an advantage is that an N-type ohmic contact can be directly formed to the first light-emitting unit, and the depth of the second trench structure can be flexibly customized at the back; and a disadvantage lies in that a pattern has been defined for the first light-emitting unit during bonding, which needs to be combined with the driving backplane with particular precision, and increases process costs.

For the design concept of the back trench structure in the foregoing embodiment, S2 may specifically include the following steps.

S221: Combine the inorganic compound semiconductor prepared with a bonding layer and the driving backplane prepared with a bonding layer through a hybrid bonding process, and during combining, the inorganic compound semiconductor is in conduction with the anode contact in the driving backplane through the bonding layer.

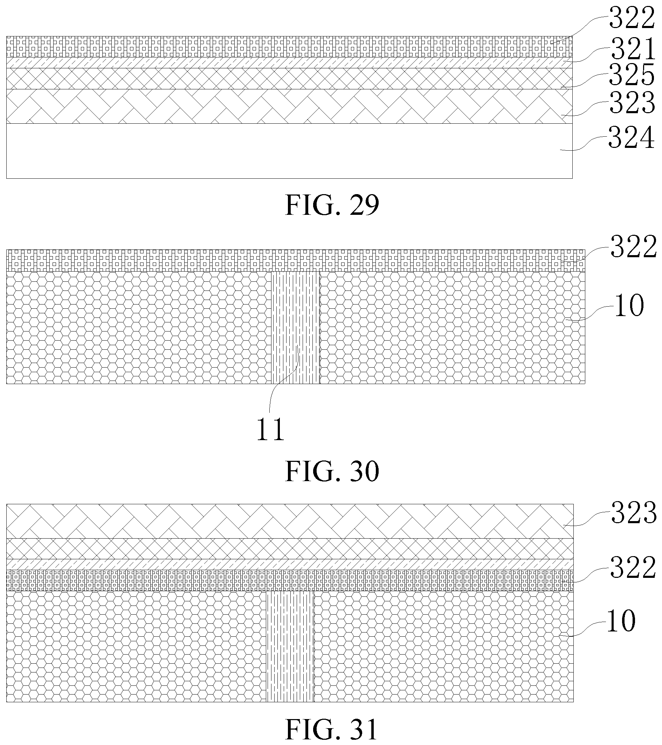

Specifically, as shown in FIG. 29 and FIG. 30, the bonding layer 322 is prepared on the inorganic compound semiconductor. Similarly, the bonding layer 322 is prepared on a wafer of the driving backplane 10. A combined structure is shown in FIG. 31. The bonding layer 322 is electrically conductive, and may be a non-transparent metal material, for example, a single layer or a plurality of layers of a metal such as Au, Sn, Al, Cu, or W. Alternatively, the bonding layer 322 may be a transparent metal oxide material, for example, a transparent conductive film such as ITO or ZnO.

Further, metals such as Cr, Ni, Ti, and TiN are used as an adhesion layer between the inorganic compound semiconductor/driving backplane 10 and the bonding layer 322, to improve adhesion between them. Further, as shown in FIG. 31, after a bonding process is performed to integrate the compound wafer and the wafer of the driving backplane 10, the second substrate 324 of the inorganic compound semiconductor may be removed, to prepare a subsequent device.

S222: Perform step etching on the inorganic compound semiconductor and the bonding layer to prepare a second light-emitting unit.

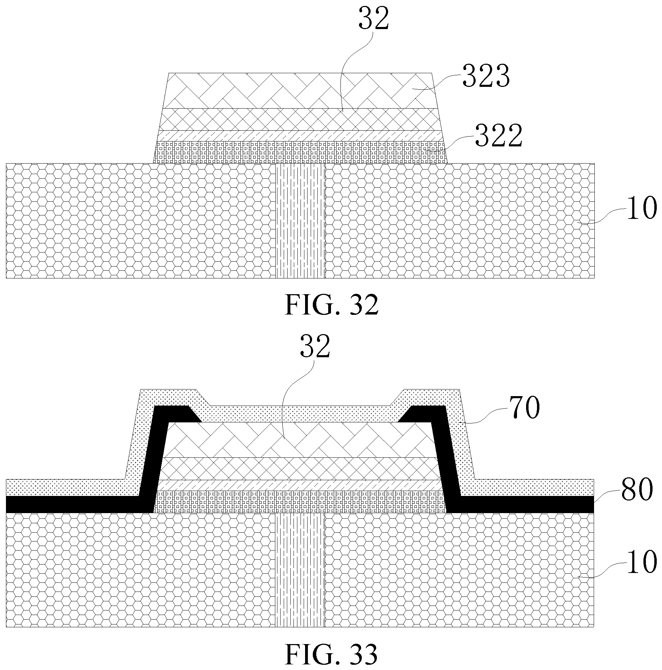

Specifically, as shown in FIG. 32, step etching is performed by using a pattering etching solution such as plasma dry etching, to complete preparation of the second light-emitting unit 32 and pattering of the bonding layer 322. An etching depth corresponding to the second light-emitting unit 32 is in an interval of 0.3 um to 3 um.

S223a: Cover a surface of the second light-emitting unit and a surface of the driving backplane with a passivation layer; remove a part of the passivation layer on a top surface of the second light-emitting unit through a patterning process, to expose a second N-type ohmic contact layer in the second light-emitting unit; cover a surface of the second N-type ohmic contact layer and a surface of the passivation layer with a cathode layer; perform step filling on the second light-emitting unit by using an insulating material, to form a third insulation layer; etch the third insulation layer to form a third trench structure surrounding the second light-emitting unit; and fill the third trench structure with a metal material.

In step S223a, the common cathode connection is before the trench process, and the microdisplay light-emitting pixel fabricated in this step is shown in FIG. 10 and FIG. 11. Specifically, after passivation and patterned opening, the second N-type ohmic contact layer 323 in the second light-emitting unit 32 is exposed for contact preparation. Then, the cathode layer 70 is prepared, and a structure of the prepared cathode layer 70 is shown in FIG. 33. The cathode layer 70 is connected to a transparent conductive film as a common cathode. The transparent conductive film may be a single layer or a plurality of layers of transparent conductive films such as ITO and ZnO. In some embodiments, a resistance and a transmittance of the transparent conductive film may be optimized by doping with metals such as Au, Ag, and Al. Then, the third insulation layer 63 is prepared by further growing the medium layer and using a plasma deposition process such as silicon glass, and the third trench structure 43 is etched after the third insulation layer 63 is planarized. A thickness of the third insulation layer 63 and a depth of the third trench structure 43 are greater than or equal to a depth of pixel etching, and usually ranges from 0.4 um to 5 um. A width of the third trench structure 43 ranges from 90 nm to 5 um. An angle of the third trench structure 43 is 90°±30°, and is optimal at 90°±10°. After the etching, metal filling is performed. For example, metals Al, NiV, and Cu are sequentially disposed in the third trench structure 43; or metal Al is disposed in the third trench structure 43; or metal W is disposed in the third trench structure 43. In this structure, both optical pixel string isolation and electrical connection of the cathode may be completed. A seed layer corresponding to the filled metal material may further be a single layer or a plurality of layers of metals such as Ti, Ni, Cr, Au, Ge, Al, Pt, Ta, W, or their nitrides. Further, after the filling is completed, CMP may be adopted to remove excess metal on the surface and planarize the surface of the filled metal material. Further, during a process for preparing the third trench structure 43, the IO and the peripheral common cathode may be synchronously filled with metal, thereby improving a function.

S223b: Perform step filling on the second light-emitting unit by using an insulating material, to form a third insulation layer; etch the third insulation layer to form a third trench structure surrounding the second light-emitting unit; fill the third trench structure with a metal material; remove a part of the third insulation layer on a top surface of the second light-emitting unit through a patterning process, to expose a second N-type ohmic contact layer in the second light-emitting unit; and cover a surface of the second N-type ohmic contact layer and a surface of a side of the third insulation layer that is away from the driving backplane with a cathode layer.

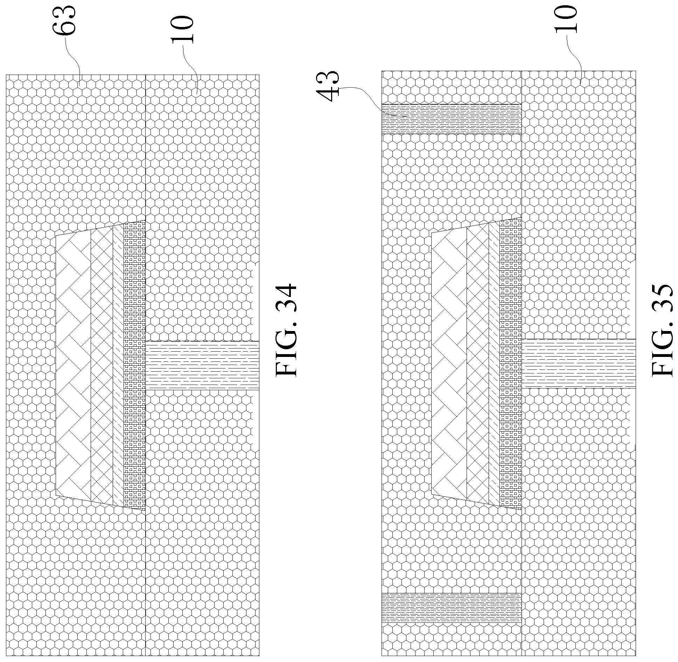

In step S223b, the trench process is before the common cathode connection, and the microdisplay light-emitting pixel fabricated in this step is shown in FIG. 12. Specifically, the third insulation layer 63 is directly introduced after the second light-emitting unit 32 is prepared, and the third insulation layer 63 is prepared by further growing the medium layer and using a plasma deposition process such as silicon glass. A structure after the introduction of the third insulation layer 63 is shown in FIG. 34. Then, the third trench structure 43 is etched after the third insulation layer 63 is planarized, the medium layer on the driving backplane 10 is over etched, and metal filling is performed after the etching. For example, metals Al, NiV, and Cu are sequentially disposed in the third trench structure 43; or metal Al is disposed in the third trench structure 43; or metal W is disposed in the third trench structure 43, and a structure after the metal filling is shown in FIG. 35. In this structure, both optical pixel string isolation and electrical connection of the cathode may be completed. A seed layer corresponding to the filled metal material may further be a single layer or a plurality of layers of metals such as Ti, Ni, Cr, Au, Ge, Al, Pt, Ta, W, or their nitrides. Further, after the filling is completed, CMP may be adopted to remove excess metal on the surface and planarize the surface of the filled metal material. Then patterned opening is performed, and the second N-type ohmic contact layer 323 in the second light-emitting unit 32 is exposed for contact preparation, to connect to the cathode layer 70.

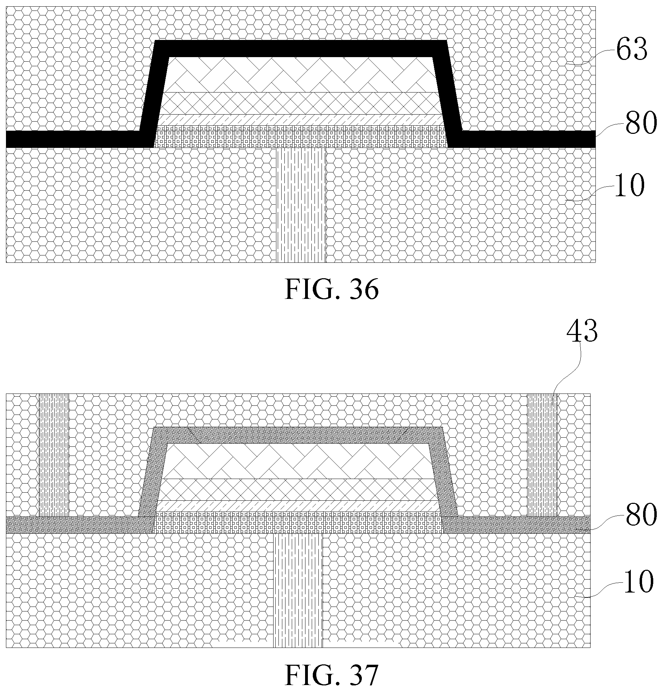

In a possible implementation, in S223b, before the performing step filling on the second light-emitting unit by using an insulating material, to form a third insulation layer, the method further includes the following step: covering the surface of the second light-emitting unit and the surface of the driving backplane with a passivation layer. That is, the passivation layer 80 is used as a corresponding etch stop layer for trench preparation. A structure after the step filling is shown in FIG. 36, a structure after the trench etching and the metal filling is shown in FIG. 37, and a microdisplay light-emitting pixel fabricated in this step is shown in FIG. 13.

It may be understood that, if the design concept of the back trench structure is adopted, advantages are that a pattern of the second light-emitting unit has not been defined when bonding, a precision requirement is very low when combining with the driving backplane, and the depth of the third trench structure can be flexibly customized by adjusting the thickness of the third insulation layer; and a disadvantage lies in that the N-type ohmic contact corresponding to the second light-emitting unit needs to be separately prepared.

In conclusion, according to the method for preparing a microdisplay light-emitting pixel provided in this embodiment of this application, the trench structure is etched in the display module of the microdisplay light-emitting pixel, and the metal material is filled in the trench structure. Through the through-type trench structure, better optical crosstalk isolation is implemented, and a depth of the trench structure can be customized to constrain the emission angle. In addition, the design process of the trench structure is relatively mature, with guaranteed mass production and yield.

Further, the preparation method uses a semiconductor technology, which may be compatible with operation at the nanometer level, making it more suitable for the preparation of micro-pixel sizes.

Any combination of all the foregoing optional technical solutions may be used to form optional embodiments of this application, that is, a plurality of embodiments may be combined randomly, to obtain requirements for dealing with different application scenarios, all of which fall within the protection scope of this application, and details are not described herein again.

It should be noted that, the foregoing descriptions are merely preferred embodiments of the present invention, and are not intended to limit the present invention. Any modification, equivalent replacement, and improvement made without departing from the spirit and principle of the present invention shall fall within the protection scope of the present invention.

## Claims

1. An anti-crosstalk microdisplay light-emitting pixel, wherein a size of the microdisplay light-emitting pixel is in an interval of 0.5 um to 50 um, and the microdisplay light-emitting pixel comprises:
a driving backplane; and
a display module, the display module being disposed on the driving backplane, the display module comprising a light-emitting unit and a trench structure, the light-emitting unit being in conduction with an anode contact in the driving backplane, the trench structure surrounding the light-emitting unit and penetrating through a vertical area in which the display module is located, the trench structure being filled with a metal material, and the light-emitting unit being an inorganic compound semiconductor.

2. The microdisplay light-emitting pixel according to claim 1, wherein the display module comprises at least a first display device layer; and the first display device layer comprises:
a first light-emitting unit, a first P-type ohmic contact layer in the first light-emitting unit being connected to a via, and the first light-emitting unit being in conduction with the anode contact in the driving backplane through the via filled with a metal material;
a first insulation layer, the first insulation layer being filled and formed outside the first light-emitting unit; and
a first trench structure, the first trench structure penetrating through the first insulation layer, one end of the first trench structure being connected to a first N-type ohmic contact layer in the first light-emitting unit, and the other end being connected to an upper surface of the driving backplane.

3. The microdisplay light-emitting pixel according to claim 2, wherein
a surface size of the via is less than a surface size of the first P-type ohmic contact layer.

4. The microdisplay light-emitting pixel according to claim 3, wherein
the surface size of the via is greater than a surface size of the anode contact in the driving backplane.

5. The microdisplay light-emitting pixel according to claim 2, wherein the display module further comprises a second display device layer disposed above the first display device layer; and the second display device layer comprises:
a second insulation layer, the second insulation layer being filled and formed on a side of the first display device layer that is away from the driving backplane; and
a second trench structure, the second trench structure penetrating through the second insulation layer and the first N-type ohmic contact layer, and one end of the second trench structure being connected to the first trench structure.

6. The microdisplay light-emitting pixel according to claim 5, wherein
a width of the second trench structure is less than a width of the first trench structure.

7. The microdisplay light-emitting pixel according to claim 2, wherein
the first N-type ohmic contact layer comprises a first part and a second part that are stacked in a direction away from the driving backplane, a surface size of the second part is greater than a surface size of the first part, and one end of the first trench structure is connected to the second part.

8. The microdisplay light-emitting pixel according to claim 7, wherein
a second trench structure is connected above the first trench structure, and a bottom of the second trench structure penetrates through the second part, so that the second trench structure is connected to the first trench structure.

9. The microdisplay light-emitting pixel according to claim 1, wherein the display module comprises at least a third display device layer; and the third display device layer comprises:
a second light-emitting unit, a bonding layer being provided between a second P-type ohmic contact layer in the second light-emitting unit and the driving backplane, the second light-emitting unit being in conduction with the anode contact in the driving backplane through the bonding layer, and a surface of the second N-type ohmic contact layer in the second light-emitting unit being covered with a part of cathode layer;
a third insulation layer, the third insulation layer being filled and formed outside the second light-emitting unit; and
a third trench structure, the third trench structure penetrating through the third insulation layer, and one end of the third trench structure being connected to the cathode layer.

10. The microdisplay light-emitting pixel according to claim 9, wherein the cathode layer comprises a central cathode layer and side cathode layers on two sides, and the central cathode layer covers the surface of the second N-type ohmic contact layer; and
a side wall of the second light-emitting unit and a surface of the driving backplane are covered with a passivation layer, and the side cathode layers cover a surface of the passivation layer;
or
the side cathode layers cover a surface of a side of the third insulation layer that is away from the driving backplane.

11. The microdisplay light-emitting pixel according to claim 10, wherein
when the side cathode layer covers the surface of the side of the third insulation layer that is away from the driving backplane, the side wall of the second light-emitting unit and the surface of the driving backplane are further covered with a passivation layer.

12. The microdisplay light-emitting pixel according to claim 1, wherein
trench structures corresponding to adjacent light-emitting units are connected to each other;
or
trench structures corresponding to adjacent light-emitting units are isolated from each other by using an insulating medium.

13. The microdisplay light-emitting pixel according to claim 1, wherein a trench pattern of the trench structure in a top view comprises:
one of a circle, a rectangle, a hexagon, and an octagon.

14. The microdisplay light-emitting pixel according to claim 1, wherein the display module further comprises a micro lens; and
the micro lens is disposed on the light-emitting unit and the trench structure.

15. The microdisplay light-emitting pixel according to claim 1, wherein the metal material filled in the trench structure comprises:
aluminum, nickel vanadium, and copper deposited vertically in sequence; or
deposited aluminum; or
deposited tungsten.

16. The microdisplay light-emitting pixel according to claim 1, wherein
an overall depth of the trench structure is not less than an overall depth of the light-emitting unit.

17. The microdisplay light-emitting pixel according to claim 1, wherein
a width of the trench structure is in an interval of 90 nm to 5 um.

18. The microdisplay light-emitting pixel according to claim 1, wherein
a depth of the trench structure is in an interval of 0.4 um to 5 um.

19. The microdisplay light-emitting pixel according to claim 1, wherein
an angle of the trench structure gradually increases along a direction away from the driving backplane.

20. A method for preparing a microdisplay light-emitting pixel, wherein the method is used for preparing the microdisplay light-emitting pixel according to any one of claims 1 to 19, and the method comprises:
preparing a driving backplane; and
preparing a display module combined on the driving backplane, the display module comprising a light-emitting unit and a trench structure, the light-emitting unit being in conduction with an anode contact in the driving backplane, the trench structure surrounding the light-emitting unit and penetrating through a vertical area in which the display module is located, the trench structure being filled with a metal material, and the light-emitting unit being an inorganic compound semiconductor.

21. The method according to claim 20, wherein the preparing a display module combined on the driving backplane comprises:
performing step etching on the inorganic compound semiconductor to prepare a first light-emitting unit;
performing step filling on the first light-emitting unit by using an insulating material, to form a first insulation layer;
etching the first insulation layer to form a via connected to a first P-type ohmic contact layer in the first light-emitting unit and a first trench structure surrounding the first light-emitting unit;
filling the via and the first trench structure with a metal material, and the first light-emitting unit, the first insulation layer, and the first trench structure being combined to form a first display device layer; and
combining the first display device layer with the driving backplane through a hybrid bonding process, and during combining, the first light-emitting unit being in conduction with the anode contact in the driving backplane through the via filled with a metal material.

22. The method according to claim 21, wherein after the combining the first display device layer with the driving backplane, the method further comprises:
removing a compound substrate in a first light-emitting unit; and
performing surface coarsening on the first light-emitting unit after the substrate is removed.

23. The method according to claim 21, wherein after forming the first display device layer, the method further comprises:
filling the first display device layer with an insulating material to form a second insulation layer;
etching the second insulation layer to form a second trench structure with one end connected to the first trench structure; and
filling the second trench structure with a metal material, and the second insulation layer and the second trench structure being combined to form a second display device layer.

24. The method according to claim 20, wherein the preparing a display module combined on the driving backplane comprises:
combining the inorganic compound semiconductor prepared with a bonding layer and the driving backplane prepared with a bonding layer through a hybrid bonding process, and during combining, the inorganic compound semiconductor being in conduction with the anode contact in the driving backplane through the bonding layer;
performing step etching on the inorganic compound semiconductor and the bonding layer to prepare a second light-emitting unit;
performing step filling on the second light-emitting unit by using an insulating material, to form a third insulation layer; etching the third insulation layer to form a third trench structure surrounding the second light-emitting unit; filling the third trench structure with a metal material; removing a part of the third insulation layer on a top surface of the second light-emitting unit through a patterning process, to expose a second N-type ohmic contact layer in the second light-emitting unit; and covering a surface of the second N-type ohmic contact layer and a surface of a side of the third insulation layer that is away from the driving backplane with a cathode layer;
or
covering a surface of the second light-emitting unit and a surface of the driving backplane with a passivation layer; removing a part of the passivation layer on a top surface of the second light-emitting unit through a patterning process, to expose a second N-type ohmic contact layer in the second light-emitting unit; covering a surface of the second N-type ohmic contact layer and a surface of the passivation layer with a cathode layer; performing step filling on the second light-emitting unit by using an insulating material, to form a third insulation layer; etching the third insulation layer to form a third trench structure surrounding the second light-emitting unit; and filling the third trench structure with a metal material.

25. The method according to claim 24, wherein in the method of covering a surface of the second N-type ohmic contact layer and a surface of a side of the third insulation layer that is away from the driving backplane with a cathode layer, before the performing step filling on the second light-emitting unit by using an insulating material, to form a third insulation layer, the method further comprises:
covering the surface of the second light-emitting unit and the surface of the driving backplane with a passivation layer.

26. The method according to claim 20, wherein after the preparing a display module combined on the driving backplane, the method further comprises:
preparing a micro lens on the light-emitting unit and the trench structure.
